# EUROPÄISCHE PATENTSCHRIFT

(11) **EP 2 249 682 B1**
(45) Veröffentlichungstag und Bekanntmachung des Hinweises auf die Patenterteilung: **04.01.2012**
(21) Anmeldenummer: 09777676.9
(22) Anmeldetag: 05.08.2009
(51) Int. Cl.: A47B 91/02

(54) **KIPPSCHUTZVORRICHTUNG UND SCHRANK**
ANTI-TIP DEVICE AND CABINET
DISPOSITIF ANTI-BASCULEMENT ET ARMOIRE

(30) Priorität: 08.08.2008 DE 102008037133
(43) Veröffentlichungstag der Anmeldung: 17.11.2010
(73) Patentinhaber: Knürr GmbH, 94424 Arnstorf (DE)
(72) Erfinder: BLÖCHL, Alfred, 84347 Pfarrkirchen (DE); JOHANN, Stefan, 94522 Altenbuch (DE); SCHWINGHAMMER, Mario, 94424 Arnstorf (DE); HUPFLOHER, Helmut, 94424 Arnstorf (DE); REISER, Patrick, 84333 Malgersdorf (DE); KALTENBERGER, Alfons, 94434 Simbach (DE); SCHWARZMEIER, Alois, 94428 Eichendorf (DE)
(74) Vertreter: Heim, Florian Andreas
(86) Internationale Anmeldenummer: PCT/EP2009/005673
(87) Internationale Veröffentlichungsnummer: WO 2010/015396

(56) Entgegenhaltungen:
- US-A- 3 322 480
- US-A- 4 624 511
- US-A- 4 836 624
- US-A1- 2004 174 105

## Beschreibung

Die Erfindung betrifft eine Kippschutzvorrichtung, insbesondere für Schränke der Informationstechnik, mit einer Stützschiene, welche einen Fußbereich zum Abstützen an einer Bodenoberfläche aufweist.

Die Erfindung betrifft ferner einen Schrank.

Elektronische Geräte, wie beispielsweise Server, werden häufig in Schränken, sogenannten Serverschränken, angeordnet. Diese Serverschränke dienen insbesondere dazu, eine Vielzahl von Servern oder anderen elektronischen Geräten platzsparend unterzubringen. Aufgrund der häufig begrenzten Aufstellungsfläche für solche Schränke werden die Geräte meist in einer vertikalen Anordnung in den Schränken angeordnet.

Zum Schutz der Geräte haben die Schränke meist eine geschlossene äußere Kontur mit einer frontseitigen Tür. Die Geräte sind üblicherweise schubladen- oder auszugartig angeordnet und können für einen besseren Zugang horizontal ausgezogen werden. Hierbei wird das elektronische Gerät aus der äußeren Kontur des Schrankes herausbewegt, wodurch sich der Schwerpunkt des Schrankes verlagert. Bei schweren Geräten oder mehreren gleichzeitig herausgezogenen Schubladen besteht die Gefahr, dass der Schwerpunkt aus der Aufstellungsfläche des Schrankes herauswandert und der Schrank nach vorne kippt.

Zum Verhindern eines solchen Kippens ist eine Vielzahl von Vorrichtungen bekannt. Es ist beispielsweise bekannt, manuell an dem Schrank zu befestigende Stützelemente vorzusehen, welche vor dem Herausziehen einer Schublade an dem Schrank zu montieren sind.

Weiterhin ist es bekannt, die Grundfläche des Schrankes durch horizontal ausziehbare Elemente zu vergrößern.

Eine solche Kippsicherung geht beispielsweise aus der US 6,857,711 B1 hervor. Beim Öffnen der Tür des Schrankes wird ein Stabilisationselement horizontal aus einem Bodenabschnitt des Schrankes herausgefahren und erhöht somit die Standsicherheit des Schrankes.

Eine weitere Kippsicherung ist aus der US 2004/0174105 A1 bekannt. Bei dieser Sicherung werden zur Erhöhung der Standsicherheit Querarme mit Hilfsfüßen um eine vertikale Achse im Bodenbereich des Schrankes ausgeklappt.

Aus der US 4,215,839 ist ein faltbares Dreibein für eine Kamera oder ein ähnliches Gerät mit einem Zentralholm und drei hieran angelenkten Füßen bekannt. Die Füße umfassen einen Schlitz, in welchem ein Ende eines Verbindungsarms verschiebbar geführt ist. Das andere Ende des Verbindungsarms ist schwenkbar an einem unteren Bereich des Zentralholms angelenkt.

DE 299 01 073 U1 beschreibt einen Kippschutz für ein kippgefährdetes Bauteil, insbesondere einen Schrank zur Aufnahme von Einrichtungen der Daten- und Telekommunikation. Der Kippschutz besteht aus einem Sockel, der sowohl an der Vorderseite als auch an den Seiten zur Aufstellebene geneigt ausgebildet ist.

US 7,185,872 B2 offenbart eine Einrichtung zum Befestigen eines Geräts an einer Stützstruktur, wie beispielsweise einer Wand. Die Vorrichtung weist Stützelemente auf, die schwenkbar an dem abzustützenden Gerät angeordnet sind und Öffnungen aufweisen, so dass die Stützelemente an der Stützstruktur befestigt werden können.

Aus US 3,322,480 ist eine Kippschute vorrichtung laut dem Oberbegriff des Anspruchs 1 bekannt.

Der Erfindung liegt die **Aufgabe** zugrunde, eine Kippschutzvorrichtung und einen Schrank mit einer Kippschutzvorrichtung zu schaffen, wobei die Kippschutzvorrichtung einfach zu handhaben ist und platzsparend angeordnet werden kann.

Die Aufgabe wird erfindungsgemäß durch eine Kippschutzvorrichtung mit den Merkmalen des Anspruchs 1 gelöst. Die Aufgabe wird ferner durch einen Schrank mit den Merkmalen des Anspruchs 10 gelöst. Bevorzugte Ausführungsformen sind in den jeweiligen abhängigen Ansprüchen angegeben.

Bei der erfindungsgemäßen Kippschutzvorrichtung ist vorgesehen, dass die Stützschiene einen Verschiebebereich aufweist, welcher entlang einer Führungsschiene verschiebbar ist, dass die Stützschiene zwischen einer Abstützposition, in welcher die Stützschiene schräg zur Führungsschiene ausgestellt ist, und einer Rückzugsposition, in welcher die Stützschiene in Richtung zur Führungsschiene eingeschwenkt ist, verstellbar ist, und dass die Stützschiene in der Abstützposition fixierbar ist.

Der Schrank ist erfindungsgemäß dadurch gekennzeichnet, dass eine derartige Kippschutzvorrichtung angeordnet ist.

Unter Schränken können nachfolgend insbesondere Einrichtungen zur Aufnahme von elektronischen Bauteilen und/oder Komponenten, wie Servern, Netzwerk-, Telekommunikations- und/oder Datenverarbeitungskomponenten sowie Bauteilen zur Energiewandlung oder -verteilung verstanden werden. Ein Schrank im Sinne der Erfindung kann ein Gehäuse beliebiger Größe sein. Schränke zur Aufnahme der oben genannten Bauteile werden häufig als Serverschränke, Serverracks, 19"-Racks, Netzwerkschränke oder Telekommunikationsschränke bezeichnet.

Ein Grundgedanke der Erfindung kann darin gesehen werden, die Stützschiene nicht, wie im Stand der Technik bekannt, lediglich auszuschwenken, sondern zusätzlich zum Ausschwenken linear zu verschieben. Durch die Kombination von Schwenkbewegung und translatorischer Bewegung kann die Kippschutzvorrichtung besonders vorteilhaft an einem Schrank positioniert werden.

Der Verschiebebereich der Stützschiene ist vorzugsweise an einem dem Fußbereich der Schiene gegenüberliegenden Ende der Stützschiene angeordnet. An der Führungsschiene ist eine Führungsstruktur ausgebildet, welche mit dem Führungsbereich derart zusammenwirkt, dass die eine Führung der Stützschiene entlang der Führungsschiene erreicht wird.

Die Verschiebbarkeit der Stützschiene ermöglicht es insbesondere, die Stützschiene an einem seitlichen Bereich eines Schrankes anzuordnen und um eine horizontale Achse auszuschwenken. Dabei ist es nicht erforderlich, die Stützschiene zum Kontaktieren mit der Bodenoberfläche zu verlängern, beispielsweise durch Vorsehen einer teleskopisch ausfahrbaren Stützschiene. Vielmehr wird das Kontaktieren mit der Bodenoberfläche im Wesentlichen durch das Verschieben der Stützschiene entlang der Führungsschiene erreicht. Im Vergleich zu bekannten Kippschutzvorrichtungen wird damit der Einsatzbereich der Kippschutzvorrichtung deutlich erweitert und die Handhabung verbessert. Die Fixierung der Stützschiene in der Abstützposition kann insbesondere dadurch erreicht werden, dass die Stützschiene an der Führungsschiene und/oder dem Schrank befestigt oder fixiert wird, so dass die Stützschiene in einer definierten Position relativ zur Führungsschiene und/oder zum Schrank gehalten wird.

Eine besonders kompakte Kippschutzvorrichtung wird dadurch erreicht, dass die Stützschiene, insbesondere dessen Verschiebebereich, in der Führungsschiene verschiebbar gelagert ist. Hierzu weist die Führungsschiene eine hohle Form zur Aufnahme des Verschiebebereichs auf.

Eine weitere bevorzugte Ausführungsform der Kippschutzvorrichtung ist dadurch gegeben, dass die Stützschiene in der Rückzugsposition in der Führungsschiene aufgenommen ist. Die Führungsschiene weist hierzu vorzugsweise einen Aufnahmeraum auf, welcher mindestens die Länge der Stützschiene aufweist. Die Stützschiene kann in die Führungsschiene eingeschwenkt werden und ist dann zumindest teilweise, vorzugsweise vollständig, in die äußere Kontur der Führungsschiene integriert. Die Kippschutzvorrichtung hat damit in der Rückzugsposition relativ kompakte Abmessungen.

Eine besonders sichere Kippschutzvorrichtung wird erfindungsgemäß dadurch erzielt, dass der Verschiebebereich der Stützschiene eine Arretiervorrichtung zum Fixieren der Stützschiene an der Führungsschiene aufweist. Die Arretiervorrichtung kann insbesondere dazu vorgesehen sein, die Stützschiene in der Abstützposition und/oder der Rückzugsposition zu fixieren. Die Arretiervorrichtung kann beispielsweise einen Stift, Bolzen oder Anschlag aufweisen.

Eine weitere vorteilhafte Ausgestaltung der Erfindung besteht darin, dass der Verschiebebereich einen Schiebeklotz aufweist, welcher an der Stützschiene angelenkt ist, und dass der Schiebeklotz an der Führungsschiene verschiebbar geführt ist. Durch den Schiebeklotz wird zum einen die Verschiebbarkeit der Stützschiene an der Führungsschiene erzielt. Zum anderen dient der Schiebeklotz als Lagerung der Stützschiene.

Bevorzugt ist es, wenn mittels der Arretiervorrichtung der Schiebeklotz an der Führungsschiene fixierbar ist. Zu den oben genannten Funktionen des Schiebeklotzes kommt somit eine weitere Funktion hinzu, nämlich die Arretierung der Stützschiene an der Führungsschiene. Die Arretiervorrichtung kann zum Fixieren des Schiebeklotzes einen Stift, Bolzen oder Anschlag aufweisen.

Die Stabilität der Kippschutzvorrichtung wird erfindungsgemäß dadurch erhöht, dass zwei Stützstreben vorgesehen sind, welche an der Führungsschiene und an der Stützschiene angelenkt sind. Die Stützstrebe stellt neben dem Verschiebebereich der Stützschiene beziehungsweise dem Schiebeklotz eine weitere Verbindung zwischen Stützschiene und Führungsschiene dar. Durch die Stützstrebe wird der Freiheitsgrad der Stützschiene reduziert. Beim Fixieren des Verschiebebereiches relativ zur Führungsschiene wird durch die Stützstrebe zudem die Ausrichtung der Stützschiene gegenüber der Führungsschiene definiert und festgelegt. Hierdurch wird eine stabile, feststehende Abstützposition der Stützschiene erreicht. Eine bevorzugte Abstützposition ist dadurch gegeben, dass ein Bereich der Führungsschiene, die Stützstrebe und ein Bereich der Stützschiene ein Dreieck bilden.

Vorzugsweise ist die Stützstrebe an der Stützschiene etwa mittig zwischen Fußbereich und Verschiebereich angelenkt. Durch diese geometrische Gestaltung wird eine besonders stabile Kippschutzvorrichtung erreicht.

Weiterhin ist es bevorzugt, wenn die Stützstrebe in der Abstützposition etwa rechtwinklig zur Führungsschiene ausgerichtet ist. Auch dies bewirkt eine hohe Stabilität der Kippschutzvorrichtung.

Eine besonders kompakte Kippschutzvorrichtung wird erreicht, wenn die Länge der Stützstrebe etwa der Länge der Führungsschiene entspricht, so dass die Stützschiene in der Rückzugsposition in der Führungsschiene aufgenommen werden kann.

Die Stützschiene und die Stützstrebe können besonders einfach in die Führungsschiene eingeklappt werden, wenn die Führungsschiene einen Führungsbereich und einen Aufnahmebereich aufweist, die Stützschiene in dem Führungsbereich verschiebbar geführt ist und wenn der Aufnahmebereich zur Aufnahme der Stützstrebe ausgebildet ist. Der Führungsbereich ist dabei derart ausgelegt, dass eine Linearführung der Stützschiene gegeben ist. Der Aufnahmebereich ist so geformt, dass die Stützstrebe in die äußeren Abmessungen der Führungsschiene integrierbar ist. Zusätzlich sind Führungsbereich und Aufnahmebereich so gestaltet, dass neben der Funktion der Führung der Stützschiene beziehungsweise Aufnahme der Stützstrebe auch die Aufnahme der Stützschiene möglich ist. Die Stützschiene kann dann sowohl in den Führungsbereich als auch den Aufnahmebereich der Führungsschiene eingeklappt werden.

Hierzu ist es vorteilhaft, dass der Führungsbereich einen im Wesentlichen C-förmigen Querschnitt und der Aufnahmebereich einen im Wesentlichen U-förmigen Querschnitt aufweist. Durch den C-förmigen Querschnitt wird eine gute Führung erzielt, wobei der Verschiebebereich der Stützschiene beziehungsweise der Schiebeklotz von der C-förmigen Struktur umklammert wird. Der U-förmige Querschnitt des Aufnahmebereichs bietet Platz zur Aufnahme der Stützstrebe.

Bei dem erfindungsgemäßen Schrank ist es besonders bevorzugt, dass die Führungsschiene an einem, insbesondere frontseitigen, Vertikalholm des Schrankes angeordnet ist. Hierdurch wird im Vergleich zum Stand der Technik, bei dem die Kippschutzvorrichtung in einem Bodenbereich des Schrankes vorgesehen ist, eine wesentliche Platzersparnis erzielt. Die Anordnung der Kippschutzvorrichtung, insbesondere der Führungsschiene, an Vertikalholmen des Schrankes nimmt keinen zusätzlichen Raum ein, welcher anderenfalls für weitere elektronische Komponenten zur Verfügung stehen würde. Insbesondere steht die gesamte vertikale Höhe des Schrankes bis zum Boden für elektronische Komponenten zur Verfügung.

Die Kippschutzvorrichtung kann in besonders kompakter Weise angeordnet werden, wenn die Führungsschiene in einer Vertiefung eines Vertikalholmes des Schrankes angeordnet ist. Die Vertiefung kann als nutartige Vertiefung oder als Ausnehmung in einem Eckbereich des Schrankes, insbesondere eines Vertikalholmes, ausgebildet sein.

Zum Erhöhen der Stabilität des Schrankes ist es vorteilhaft, wenn mindestens zwei Kippschutzvorrichtungen an einem Schrank vorgesehen sind. Diese befinden sich vorzugsweise an zwei frontseitigen Vertikalholmen des Schrankes.

Die Erfindung wird nachfolgend anhand von beispielhaften Ausführungsformen, welche in den beigefügten Zeichnungen dargestellt sind, weiter beschrieben. In den Zeichnungen zeigt:
- Fig. 1: eine perspektivische Ansicht eines Schrankes mit einer erfindungsgemäßen Kippschutzvorrichtung;
- Fig. 2: eine vergrößerte Ansicht des Bereichs X aus Fig. 1;
- Fig. 3: eine Seitenansicht des Schrankes aus Fig. 1;
- Fig. 4: eine Frontansicht des Schrankes aus Fig. 1;
- Fig. 5: eine Querschnittsansicht entlang A-A aus Fig. 4;
- Fig. 6: eine Ausführungsform einer erfindungsgemäßen Kippschutzvorrichtung in perspektivischer Ansicht;
- Fig. 7: eine Querschnittsansicht eines Führungsbereichs der Führungsschiene;
- Fig. 8: eine Querschnittsansicht eines Aufnahmebereichs der Führungsschiene;
- Fig. 9: eine teilweise geschnittene Seitenansicht einer erfindungsgemäßen Kippschutzvorrichtung;
- Fig. 10: eine vergrößerte Ansicht des Bereichs Y der Kippschutzvorrichtung aus Fig. 9;
- Fig. 11a: eine Frontansicht einer Führungsschiene;

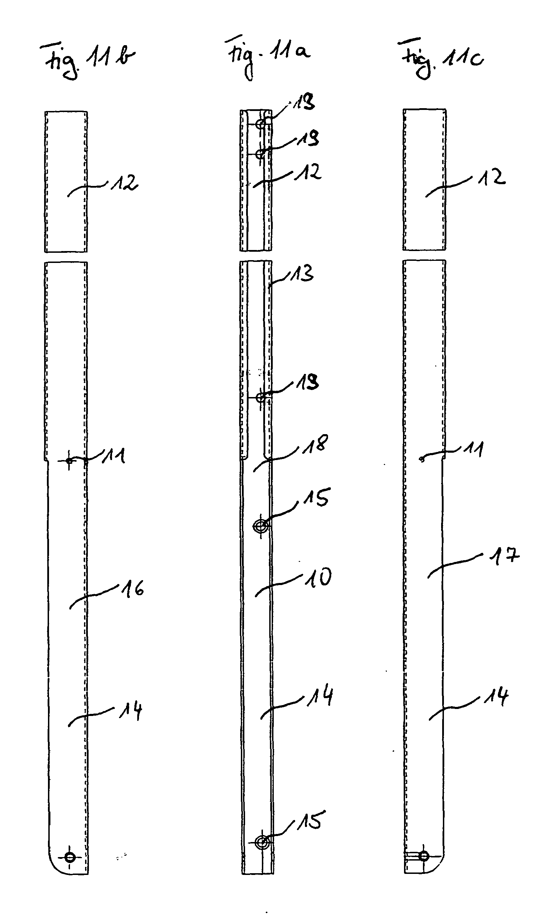

- Fig. 11 b: eine Seitenansicht einer ersten Seitenwange einer Führungsschiene; und
- Fig. 11 c: eine Seitenansicht einer zweiten Seitenwange einer Führungsschiene.

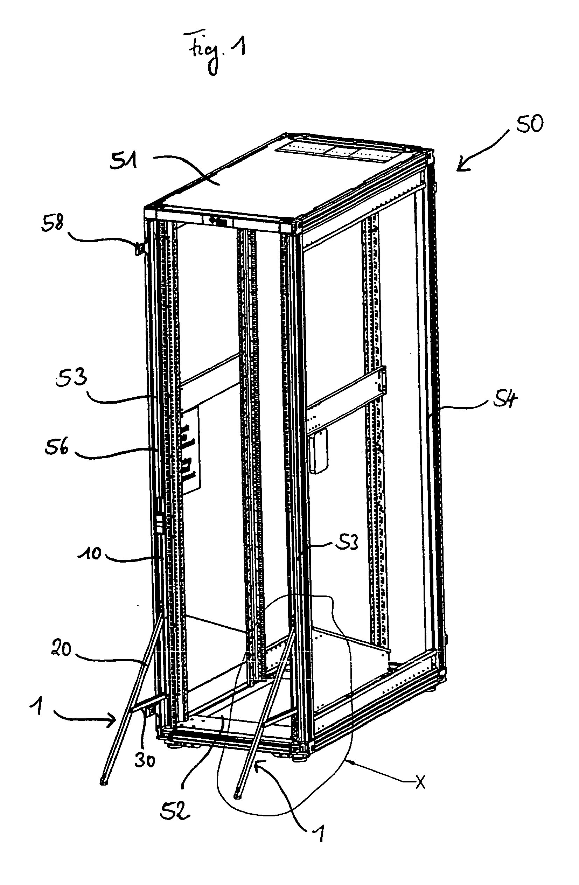

Fig. 1 zeigt ein Gehäuse 50 eines Serverschrankes mit zwei erfindungsgemäßen Kippschutzvorrichtungen 1. Hierbei ist das Gehäuse 50 ohne Seitenwände dargestellt. Auch auf die Darstellung front- und rückseitiger Türen wurde verzichtet. Das Gehäuse 50 weist eine Oberseite 51 und eine Unterseite 52 auf, zwischen denen sich zwei frontseitige Vertikalholme 53 und zwei rückseitige Vertikalholme 54 erstrecken. An den frontseitigen Vertikalholmen 53 ist jeweils eine Kippschutzvorrichtung 1 angebracht.

Jede Kippschutzvorrichtung 1 weist eine Führungsschiene 10, eine Stützschiene 20 und zwei Stützstreben 30 auf. Die Führungsschiene 10 weist eine Länge auf, welche geringer ist als die Höhe des Gehäuses 50. Zur Aufnahme der Führungsschienen 10 ist an den frontseitigen Vertikalholmen 53 des Gehäuses 50 jeweils eine sich längs entlang der Vertikalholme 53 erstreckende Nut beziehungsweise Ausnehmung 56 ausgebildet. Die Führungsschienen 10 sind in den Nuten beziehungsweise Ausnehmungen 56 befestigt.

Zum Verschließen des Gehäuses 50 kann an einer Vorderseite hiervon eine Tür vorgesehen sein. Zum Aufhängen der Tür weist das Gehäuse 50 an einem der frontseitigen Vertikalholme 53 Türaufhängungen 58 mit Scharnierbolzen auf. Die Türaufhängungen 58 sind auf einer äußeren Seite des Vertikalholmes neben der Nut beziehungsweise Ausnehmungen 56 angeordnet. Beim Verschließen der Tür wird die Nut 56 von der Tür verdeckt.

Zum Bereitstellen des Kippschutzes kann die Kippschutzvorrichtung 1 aus einer Rückzugsposition, in welcher die Stützschiene 20 und die Stützstreben 30 im Wesentlichen senkrecht angeordnet sind, in eine Abstützposition überführt werden, in welcher die Stützschiene 20 schräg zur Führungsschiene 10 ausgestellt ist. Ist an dem Gehäuse 50 eine Tür vorgesehen, so kann es zum Erreichen der Abstützposition erforderlich sein, dass die Tür geöffnet wird.

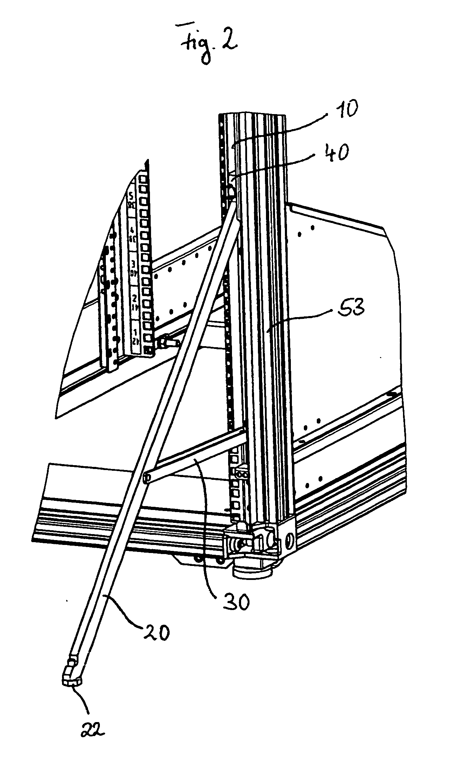

Ein mit X bezeichneter Bereich in Fig. 1 ist in Fig. 2 vergrößert dargestellt. Die Stützschiene 20 weist einen Stellfuß 22 auf, dessen Abstützfläche zum Abstützen an einer Bodenoberfläche gegenüber einer Längsachse der Stützschiene 20 geneigt ist. Um ein Ausgleichen einer unebenen Bodenoberfläche zu ermöglichen, ist der Stellfuß 22 in der Stützschiene 20 verstellbar aufgenommen. Hierzu weist die Stützschiene 20 ein Innengewinde auf, in welches der Stellfuß 22 mit einem korrespondierenden Außengewinde eingeschraubt werden kann. Durch den Stellfuß kann die Kippsicherung 1 justiert werden, das heißt nach dem Fixieren der Stützschiene 20 an der Führungsschiene 10 kann die Kippsicherung 1 auf Spannung gebracht werden, um so das Kippverhalten des Schrankes zu minimieren und unterschiedliche Bodenverhältnisse auszugleichen.

An einem dem Stellfuß 22 gegenüberliegenden Ende ist Schiebeklotz 40 vorgesehen. Der Schiebeklotz 40 dient zum einen zum Lagern und Führen der Stützschiene 20 in der Führungsschiene 10 und zum anderen zum Arretieren der Stützschiene 20 an der Führungsschiene 10.

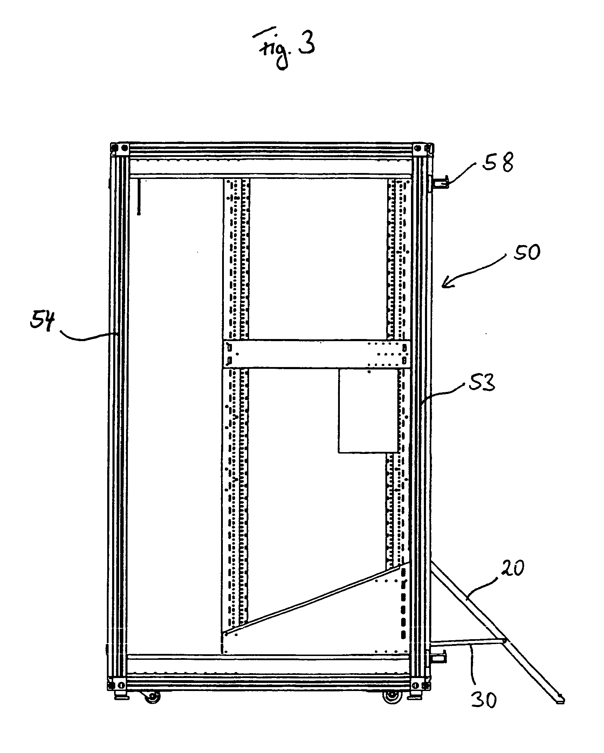

Fig. 3 zeigt eine Seitenansicht des Gehäuses 50 mit einer Kippschutzvorrichtung 1 in Abstützposition. Die Stützschiene 20 ist in einem Winkel von etwa 45° gegenüber der Vertikalen ausgestellt. Die Stützstreben 30 sind in der Abstützposition im Wesentlichen horizontal ausgerichtet.

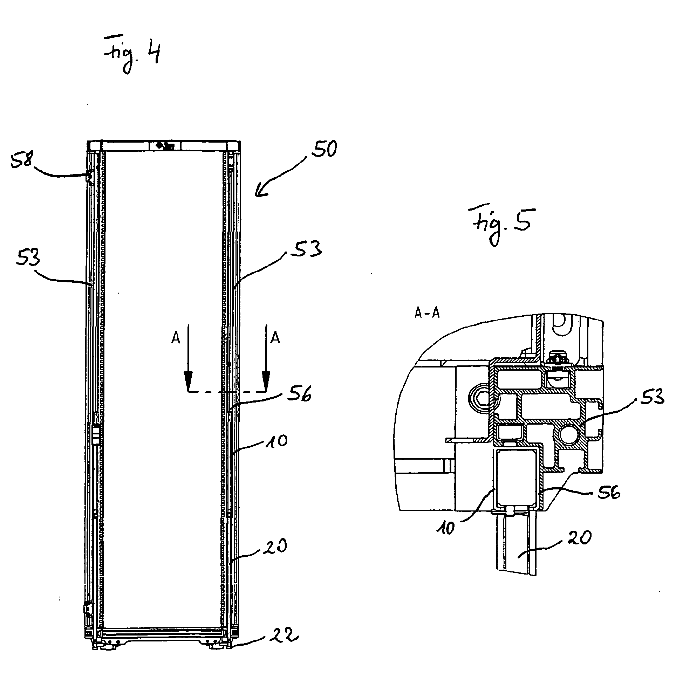

Fig. 4 zeigt eine Frontansicht des Gehäuses 50. An den beiden Vertikalholmen 53 ist jeweils eine Kippschutzvorrichtung 1 angeordnet. Die Kippschutzvorrichtungen 1 sind jeweils in einem unteren Bereich der Vertikalholme 53 vorgesehen.

Fig. 5 zeigt eine Querschnittsansicht eines Vertikalholmes 53 entlang der Linie A-A aus Fig. 4. Die Nut beziehungsweise Ausnehmung 56 in dem Vertikalholm 53 befindet sich in einem inneren, vorderen Eckbereich des Vertikalholmes 53. In einem unteren Teilbereich der Nut beziehungsweise Ausnehmung 56 ist die Führungsschiene 10 angeordnet.

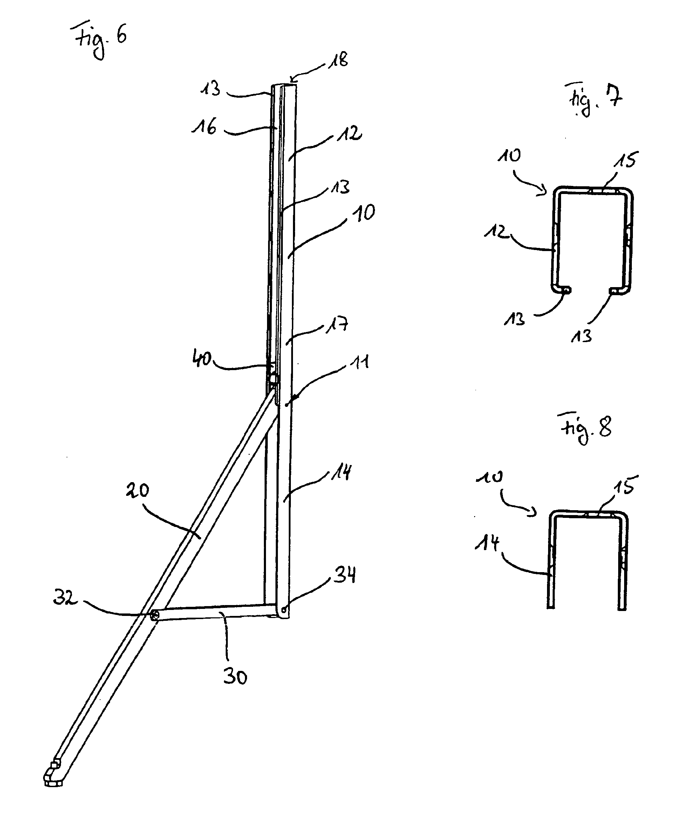

In Fig. 6 ist eine Kippschutzvorrichtung in einer perspektivischen Ansicht gezeigt. Die Führungsschiene 10 ist als Hohlprofil mit einem sich längs erstreckenden Hohlraum ausgebildet. Sie weist eine linke Seitenwange 16, eine rechte Seitenwange 17 und eine Rückseite 18 auf. In der Rückzugsposition ist die Stützschiene 20 in dem Hohlraum aufgenommen, so dass eine besonders kompakte Kippschutzvorrichtung 1 erreicht wird, bei der die Stützschiene 20 vollständig in der äußeren Kontur der Führungsschiene 10 aufgenommen ist. Die Führungsschiene 10 kann aus einem Blechbiegeteil, einem Aluminiumstrangpressprofil oder einem rolierten Profil hergestellt sein.

In einem oberen Bereich der Führungsschiene 10 ist ein Führungsbereich 12 zur Führung des Schiebeklotzes 40 ausgebildet. Fig. 7 zeigt eine Querschnittsansicht des Führungsbereichs. Dieser weist einen etwa C-förmigen Querschnitt auf, welcher dadurch gebildet ist, dass an einem U-förmigen Querschnitt zusätzliche Vorsprünge 13 gebildet sind. Im Führungsbereich 12 umschließt die Führungsschiene 10 den Schiebeklotz 40 derart, dass dieser lediglich längs entlang der Führungsschiene 10 bewegbar ist. Nach dem Zusammenbau der Kippschutzvorrichtung wird eine Bohrung 11 mit einer Blindniet oder Schraube versehen, um den Schiebeklotz 40 gegen ein Herausgleiten aus dem Führungsbereich zu sichern.

Unterhalb des Führungsbereichs 12 ist ein Aufnahmebereich 14 ausgebildet. Eine Querschnittsansicht des Aufnahmebereichs 14 ist in Fig. 8 dargestellt. Der Aufnahmebereich 14 weist einen U-förmigen Querschnitt auf. Die gegenüber dem Führungsbereich 12 fehlenden Vorsprünge ermöglichen es, dass die Stützstreben 30 neben der Stützschiene 20 im Aufnahmebereich 14 der Führungsschiene 10 aufgenommen werden können. Die Stützstreben 30 sind dann parallel zur Stützschiene 10 ausgerichtet und seitlich hiervon angeordnet.

Die Stützschiene 20 kann als Vierkantflachstahl oder Laserteil ausgebildet werden. Beidseitig an der Stützschiene 20 sind die Stützstreben 30 über ein Doppelgelenk 32 angelenkt. Die parallel zueinander angeordneten flachen Stützstreben 30 weisen einen Abstand zueinander auf, so dass zwischen ihnen ein Aufnahmeraum zur Aufnahme der Stützschiene 20 gebildet ist. Durch die beidseitige Anordnung der Stützstreben 30 an der Stützschiene 20 wird ein Verdrehen der Stützschiene 20 verhindert.

Die Stützstreben 30 sind weiterhin an der Führungsschiene 10 angelenkt. Hierbei kann vorgesehen sein, dass eine erste Stützstrebe 30 an der ersten Seitenwange 16 der Führungsschiene 10 und eine zweite Stützstrebe 30 an der zweiten Seitenwange 17 der Führungsschiene 10 angelenkt ist. Es ist aber auch möglich, die beiden Stützstreben 30 über ein Doppelgelenk an beiden Seitenwangen 16, 17 anzulenken. Ferner kann es vorteilhaft sein, die Stützstreben 30 einteilig auszubilden, wobei dann eine gabelförmige Gestaltung bevorzugt ist. Zur Befestigung der mindestens einen Stützstrebe 30 an der Führungsschiene 10 ist mindestens ein Gelenk 34 vorgesehen. Das Gelenk 34 ist an einem unteren Ende der Führungsschiene 10 angeordnet.

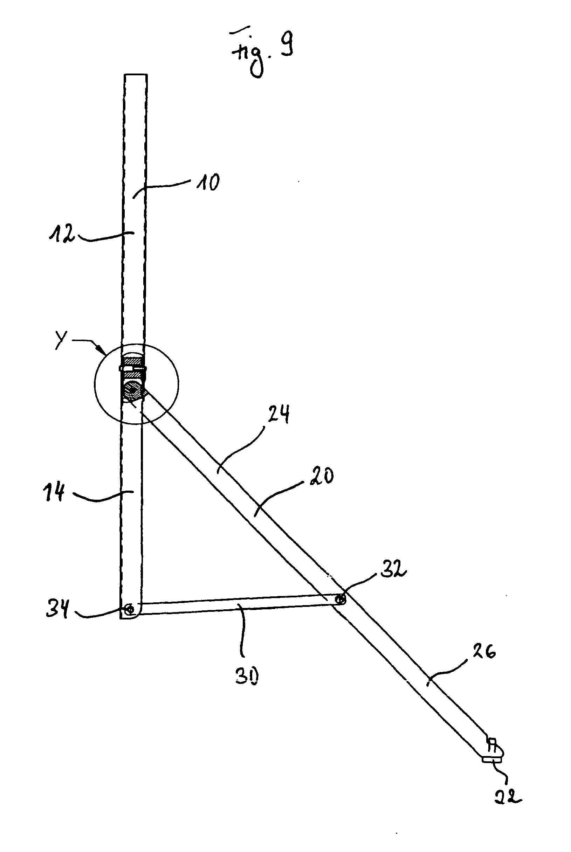

Fig. 9 zeigt eine teilweise geschnittene Seitenansicht einer Kippschutzvorrichtung 1. Die Stützschiene weist einen oberen Abschnitt 24 und einen unteren Abschnitt 26 auf, zwischen welchen das Doppelgelenk 32 angeordnet ist. Die Länge des unteren Abschnittes 26 entspricht im Wesentlichen der Länge der Stützstrebe 30 und der Länge des Aufnahmebereiches 14 der Führungsschiene 10. Hierdurch wird erreicht, dass der untere Abschnitt 26 der Stützschiene 20 und die Stützstrebe 30 in der Rückzugsposition in den Aufnahmebereich 14 der Führungsschiene 10 integrierbar sind.

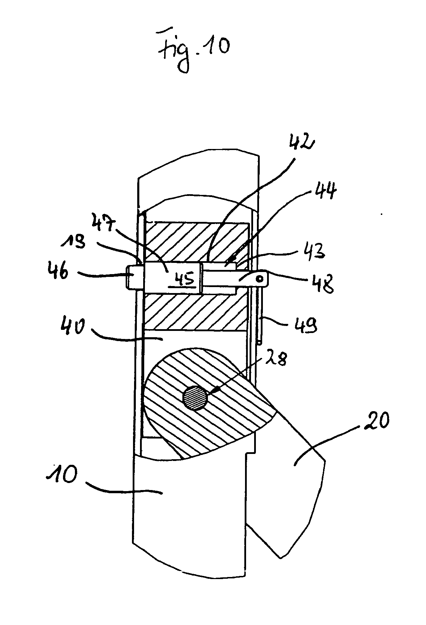

In der Darstellung ist weiterhin gezeigt, dass die Länge der Stützschiene 20 im Wesentlichen der Länge der Führungsschiene 10 entspricht. Hierdurch wird erreicht, dass die Stützschiene 20 vollständig in die Führungsschiene 10 aufgenommen werden kann. Der Bereich Y der Führungsschiene 10 mit dem Schiebeklotz 40 ist in Fig. 10 vergrößert dargestellt. Zum Fixieren des Schiebeklotzes 40 in der Führungsschiene 10 weist diese zumindest eine Einrastbohrung 19 auf, welche mit einer entsprechenden Riegeleinrichtung des Schiebeklotzes 40 korrespondiert. Die Riegeleinrichtung ist als Arretierstift 45 ausgebildet, welcher aus der Einrastbohrung 19 herausgezogen werden kann und durch eine Feder 44 wieder zur Einrastposition zurückgedrückt wird. Hierzu ist an dem Arretierstift 45 eine geeignete Ziehhilfe, beispielsweise ein Ring 49, angeordnet.

Der Arretierstift 45 ist in einer Durchgangsbohrung 42 des Schiebeklotzes 40 verschiebbar angeordnet. Die Durchgangsbohrung 42 weist zwei Bereiche mit unterschiedlichen Durchmessern auf, zwischen denen ein Absatz 43 gebildet ist. Der Arretierstift 45 weist einen Gleitbereich 47 und einen durchmesserkleineren Ansatzbereich 48 auf. Die Feder 44 ist um den Ansatzbereich 48 herum zwischen dem Gleitbereich 47 des Arretierstiftes 45 und dem Absatz 43 angeordnet. Der Arretierstift 45 weist ferner einen Einrastbereich 46 auf, welcher mit der Einrastbohrung 19 einrastend in Eingriff gebracht werden kann.

Alternativ kann die Arretierung auch als Druckknopfsystem ausgeführt sein, bei dem ein Druckknopf durch eine Feder in die Einrastbohrung 19 gedrückt wird.

Zur drehbaren Lagerung der Stützschiene 20 an dem Schiebeklotz 40 weisen Stützschiene 20 und Schiebeklotz 40 jeweils Bohrungen auf. Ein Stift 28 ist in die Bohrung in der Stützschiene 20 eingepresst und stellt die Lagerung dar.

Fig. 11a zeigt die Führungsschiene 10 in einer Frontansicht. Zur Befestigung der Führungsschiene 10 an einem Schrank, insbesondere in der Nut oder der Ausnehmung 56 des Gehäuses 50, sind an der Führungsschiene 10 mehrere Befestigungsbohrungen 15 vorgesehen. Mittels dieser Befestigungsbohrungen 15 kann die Führungsschiene 10 in die Nut 56 eingeschraubt werden. Zum Fixieren des Schiebeklotzes 40 in der Abstützposition und der Rückzugsposition sind die Einrastbohrungen 19 an einem oberen und unteren Ende des Führungsbereichs 12 der Führungsschiene 10 ausgebildet.

Die linke Seitenwange 16 ist in Fig. 11b in einer Ansicht von rechts, das heißt aus dem Inneren der Führungsschiene 10 heraus, gezeigt. Die rechte Seitenwange 17 ist in Fig. 11c in einer entsprechenden Ansicht von links gezeigt. Die Bohrungen 11 zur axialen Sicherung des Schiebeklotzes sind am Übergang zwischen Führungsbereich 12 und Aufnahmebereich 14 angeordnet.

Die Seitenwangen 16, 17 haben eine abgestufte Kontur, wobei eine Stufe den Führungsbereich 12 von dem Aufnahmebereich 14 trennt. Die Seitenwangen 16, 17 haben dabei im Führungsbereich 12 eine größere Breite als im Aufnahmebereich 14.

Die erfindungsgemäße Kippschutzvorrichtung ermöglicht somit einen Kippschutz für einen Schrank, der einfach zu handhaben ist und platzsparend angeordnet werden kann.

## Patentansprüche

1. Kippschutzvorrichtung, insbesondere für Schränke der Informationstechnik, mit einer Stützschiene (20), welche einen Fußbereich zum Abstützen an einer Bodenoberfläche aufweist, wobei
- die Stützschiene (20) einen Verschiebebereich aufweist, welcher entlang einer Führungsschiene (10) verschiebbar ist,
- die Stützschiene (20) zwischen einer Abstützposition, in welcher die Stützschiene (20) schräg zur Führungsschiene (10) ausgestellt ist, und einer Rückzugsposition, in welcher die Stützschiene (20) in Richtung zur Führungsschiene (10) eingeschwenkt ist, verstellbar ist und
- die Stützschiene (20) in der Abstützposition fixierbar ist,
**dadurch gekennzeichnet,**
- **dass** zwei Stützstreben (30) vorgesehen sind, welche an der Führungsschiene (10) und an der Stützschiene (20) angelenkt sind,
- **dass** zwischen den Stützstreben (30) ein Aufnahmeraum zur Aufnahme der Stützschiene (20) gebildet ist ,
- **dass** in der Rückzugsposition die Stützstreben (30) seitlich der Stützschiene (20) angeordnet sind und.
- **dass** der Verschiebebereich der Stützschiene (20) eine Arretiervorrichtung zum Fixieren der Stützschiene (20) an der Führungsschiene (10) aufweist.

2. Kippschutzvorrichtung nach Anspruch 1,
**dadurch gekennzeichnet,**
**dass** die Stützschiene (20) in der Rückzugsposition in der Führungsschiene (10) aufgenommen ist.

3. Kippschutzvorrichtung nach einem der Ansprüche 1 bis 2,
**dadurch gekennzeichnet,**
**dass** der Verschiebebereich einen Schiebeklotz (40) aufweist, welcher an der Stützschiene (20) angelenkt ist, und
**dass** der Schiebeklotz (40) an der Führungsschiene (10) verschiebbar geführt ist.

4. Kippschutzvorrichtung nach Anspruch 3,
**dadurch gekennzeichnet,**
**dass** eine Arretiervorrichtung vorgesehen ist, mittels welcher der Schiebeklotz (40) an der Führungsschiene (10) fixierbar ist.

5. Kippschutzvorrichtung nach einem der Ansprüche 1 bis 4,
**dadurch gekennzeichnet,**
**dass** die Stützstreben (30) an der Stützschiene (20) etwa mittig zwischen Fußbereich und Verschiebebereich angelenkt sind.

6. Kippschutzvorrichtung nach einem der Ansprüche 1 bis 5,
**dadurch gekennzeichnet,**
**dass** die Stützstreben (30) eine Länge aufweisen, welche im Wesentlichen der Hälfte der Länge der Stützschiene (20) entspricht.

7. Kippschutzvorrichtung nach einem der Ansprüche 1 bis 6,
**dadurch gekennzeichnet,**
**dass** die Stützstreben (30) in der Abstützposition im Wesentlichen rechtwinkelig zur Führungsschiene (10) ausgerichtet sind.

8. Kippschutzvorrichtung nach einem der Ansprüche 1 bis 7,
**dadurch gekennzeichnet,**
**dass** die Führungsschiene (10) einen Führungsbereich (12) und einen Aufnahmebereich (14) aufweist,
**dass** die Stützschiene (20) in dem Führungsbereich (12) verschiebbar geführt ist, und dass der Aufnahmebereich (14) zur Aufnahme der Stützstreben (30) ausgebildet ist.

9. Kippschutzvorrichtung nach Anspruch 8,
**dadurch gekennzeichnet,**
**dass** der Führungsbereich (12) einen im Wesentlichen C-förmigen Querschnitt und der Aufnahmebereich (14) einen im Wesentlichen U-förmigen Querschnitt aufweist.

10. Schrank,
**dadurch gekennzeichnet,**
**dass** eine Kippschutzvorrichtung (1) nach einem der Ansprüche 1 bis 9 angeordnet ist.

11. Schrank nach Anspruch 10,
**dadurch gekennzeichnet,**
**dass** die Führungsschiene (10) an einem, insbesondere frontseitigen, Vertikalholm (53) des Schrankes (50) angeordnet ist.

12. Schrank nach Anspruch 10 oder 11,
**dadurch gekennzeichnet,**
**dass** die Führungsschiene (10) in einer Vertiefung eines Vertikalholmes (53) des Schrankes (50) angeordnet ist.

13. Schrank nach einem der Ansprüche 10 bis 12,
**dadurch gekennzeichnet,**
**dass** mindestens zwei Kippschutzvorrichtungen (1) vorgesehen sind.

## Claims

1. Anti-tip device, especially for information technology cabinets, having a support rail (20) comprising a foot area for support on a floor surface, wherein
- the support rail (20) comprises a displacement area which can be displaced along a guide rail (10),
- the support rail (20) can be adjusted between a support position, in which the support rail (20) is moved out at an angle to the guide rail (10), and a withdrawn position, in which the support rail (20) is pivoted in towards the guide rail (10), and
- the support rail (20) can be fixed in the support position,
**characterised in that**
- two support struts (30) are provided which are hinged to the guide rail (10) and to the support rail (20),
- a receiving area for receiving the support rail (20) is formed between the support struts (30),
- in the withdrawn position the support struts (30) are arranged to the side of the support rail (20) and
- the displacement area of the support rail (20) comprises a detent device for fixing the support rail (20) on the guide rail (10).

2. Anti-tip device according to claim 1,
**characterised in that**
the support rail (20) is received in the withdrawn position in the guide rail (10).

3. Anti-tip device according to one of the claims 1 to 2,
**characterised in that**
the displacement area comprises a sliding block (40) which is hinged to the support rail (20), and
the sliding block (40) is displaceably guided on the guide rail (10).

4. Anti-tip device according to claim 3,
**characterised in that**
a detent device is provided, by means of which the sliding block (40) can be fixed on the guide rail (10).

5. Anti-tip device according to one of the claims 1 to 4,
**characterised in that**
the support struts (30) are hinged to the support rail (20) approximately centrally between the foot area and displacement area.

6. Anti-tip device according to one of the claims 1 to 5,
**characterised in that**
the support struts (30) have a length which corresponds essentially to half the length of the support rail (20).

7. Anti-tip device according to one of the claims 1 to 6,
**characterised in that**
the support struts (30) are orientated essentially at a right angle to the guide rail (10) in the support position.

8. Anti-tip device according to one of the claims 1 to 7,
**characterised in that**
the guide rail (10) comprises a guide area (12) and a receiving area (14), the support rail (20) is displaceably guided in the guide area (12), and
the receiving area (14) is designed to receive the support struts (30).

9. Anti-tip device according to claim 8,
**characterised in that**
the guide area (12) has an essentially C-shaped cross-section and the receiving area (14) has an essentially U-shaped cross-section.

10. Cabinet,
**characterised in that**
an anti-tip device (1) is arranged according to one of the claims 1 to 9.

11. Cabinet according to claim 10,
**characterised in that**
the guide rail (10) is arranged on a, particularly frontal, vertical beam (53) of the cabinet (50).

12. Cabinet according to claim 10 or 11,
**characterised in that**
the guide rail (10) is arranged in a depression of a vertical beam (53) of the cabinet (50).

13. Cabinet according to one of the claims 10 to 12,
**characterised in that**
at least two anti-tip devices (1) are provided.

## Revendications

1. Dispositif anti-basculement, en particulier pour des armoires des technologies de l'information, avec un rail d'appui (20) qui comprend une zone de pied destinée à s'appuyer sur une surface de sol, dans lequel
- le rail d'appui (20) comprend une zone de déplacement qui est mobile le long d'un rail de guidage (10),
- le rail d'appui (20) peut être déplacé entre une position d'appui, dans laquelle le rail d'appui (20) est placé à l'oblique par rapport au rail de guidage (10), et une position de retrait, dans laquelle le rail d'appui (20) est rentré en direction du rail de guidage (10), et
- le rail d'appui (20) peut être immobilisé dans la position d'appui,
***caractérisé***
- ***en ce que*** deux entretoises (30) sont présentes, qui sont articulées sur le rail de guidage (10) et sur le rail d'appui (20),
- *en ce qu*'entre les entretoises (30) est formé un logement destiné à recevoir le rail d'appui (20),
- ***en ce que**,* dans la position de retrait, les entretoises (30) sont placées latéralement par rapport au rail d'appui (20), et
- ***en ce que*** la zone de déplacement du rail d'appui (20) comprend un dispositif d'arrêt pour immobiliser le rail d'appui (20) sur le rail de guidage (10).

2. Dispositif anti-basculement selon la revendication 1, ***caractérisé en ce que**,* dans la position de retrait, le rail d'appui (20) est logé dans le rail de guidage (10).

3. Dispositif anti-basculement selon l'une quelconque des revendications 1 à 2,
***caractérisé***
***en ce que*** la zone de déplacement comprend une cale coulissante (40) qui est articulée sur le rail d'appui (20), et
***en ce que*** la cale coulissante (40) est guidée mobile sur le rail de guidage (10).

4. Dispositif anti-basculement selon la revendication 3, ***caractérisé en ce qu'**un* dispositif d'arrêt est prévu, au moyen duquel la cale coulissante (40) peut être immobilisée sur le rail de guidage (10).

5. Dispositif anti-basculement selon l'une quelconque des revendications 1 à 4, ***caractérisé en ce que*** les entretoises (30) sont articulées au rail d'appui (20) approximativement au milieu entre la zone de pied et la zone de déplacement.

6. Dispositif anti-basculement selon l'une quelconque des revendications 1 à 5, ***caractérisé en ce que*** les entretoises (30) présentent une longueur qui correspond pour l'essentiel à la moitié de la longueur du rail d'appui (20).

7. Dispositif anti-basculement selon l'une quelconque des revendications 1 à 6, ***caractérisé en ce que**,* dans la position de soutien, les entretoises (30) sont orientées pour l'essentiel perpendiculairement au rail de guidage (10).

8. Dispositif anti-basculement selon l'une quelconque des revendications 1 à 7,
***caractérisé***
***en ce que*** le rail de guidage (10) comprend une zone de guidage (12) et une zone de réception (14),
***en ce que*** le rail d'appui (20) est guidé mobile dans la zone de guidage (12),
et ***en ce que*** la zone de réception (14) est conformée pour recevoir les entretoises (30).

9. Dispositif anti-basculement selon la revendication 8, ***caractérisé en ce que*** la zone de guidage (12) comprend une section sensiblement en C et la zone de réception (14) une section sensiblement en U.

10. Armoire, *caractérisée en ce qu*'un dispositif anti-basculement (1) selon l'une quelconque des revendications 1 à 9 est prévu.

11. Armoire selon la revendication 10, ***caractérisée en ce que*** le rail de guidage (10) est placé sur un montant vertical (53), en particulier avant, de l'armoire (50).

12. Armoire selon la revendication 10 ou 11, ***caractérisée en ce que*** le rail de guidage (10) est placé dans un renfoncement d'un montant vertical (53) de l'armoire (50).

13. Armoire selon l'une quelconque des revendications 10 à 12, ***caractérisée en ce* qu'**au moins deux dispositifs anti-basculement (1) sont prévus.
